# EUROPÄISCHE PATENTSCHRIFT

(11) **EP 3 351 068 B1**
(45) Veröffentlichungstag und Bekanntmachung des Hinweises auf die Patenterteilung: **13.10.2021**
(21) Anmeldenummer: 16758106.5
(22) Anmeldetag: 16.08.2016
(51) Int. Cl.: H05K 5/00

(54) **MEDIENDICHTES STEUERGERÄT FÜR EIN KRAFTFAHRZEUG UND VERFAHREN ZUR HERSTELLUNG DES STEUERGERÄTES**
MEDIA-TIGHT CONTROL DEVICE FOR A MOTOR VEHICLE AND METHOD FOR PRODUCING THE CONTROL DEVICE
APPAREIL DE COMMANDE ÉTANCHE AUX SUBSTANCES POUR VÉHICULE À MOTEUR ET PROCÉDÉ DE RÉALISATION DE L'APPAREIL DE COMMANDE

(30) Priorität: 15.09.2015 DE 102015217576
(43) Veröffentlichungstag der Anmeldung: 25.07.2018
(73) Patentinhaber: Vitesco Technologies Germany GmbH, 30165 Hannover (DE)
(72) Erfinder: WITTMANN, Frieder, 91560 Heilsbronn (DE); BEART, Karin, 91207 Lauf an der Pegnitz (DE); BOCK, Johannes, 91056 Erlangen (DE); SCHMIDT, Thomas, 93133 Burglengenfeld (DE); SCHUCH, Bernhard, 91616 Neusitz (DE)
(74) Vertreter: Waldmann, Georg Alexander
(86) Internationale Anmeldenummer: PCT/EP2016/069397
(87) Internationale Veröffentlichungsnummer: WO 2017/045854

(56) Entgegenhaltungen:
- DE-A1-102010 062 653
- DE-A1-102012 213 917
- DE-A1-102013 215 230

## Beschreibung

Die Erfindung betrifft ein Steuergerät für ein Kraftfahrzeug und ein Verfahren zu dessen Herstellung nach dem Oberbegriff der unabhängigen Ansprüche.

In der Kraftfahrzeugtechnik werden Komponenten wie Getriebe-, Motoren- oder Bremssysteme zunehmend vornehmlich elektronisch gesteuert. Hierbei gibt es eine Entwicklung hin zu integrierten mechatronischen Steuerungen, also zur Integration von Steuerelektronik und den zugehörigen elektronischen Komponenten wie Sensoren oder Ventile in das Getriebe, den Motor oder das Bremssystem. Steuergeräte weisen also im Allgemeinen eine Vielzahl an elektronischen Komponenten auf, welche in Verbindung mit anderen Komponenten außerhalb des Steuergerätes stehen. Bei solchen "Vorort-Elektroniken" sind diese Steuerungen nicht mehr in einem separaten geschützten Elektronikraum untergebracht und müssen daher entsprechenden Umwelteinflüssen und mechanischen, thermischen sowie chemischen Beanspruchungen standhalten. Sie werden zu diesem Zweck normalerweise in spezielle Gehäuse eingesetzt.

Um eine verlässliche Verbindung zu außerhalb des Gehäuses liegenden Komponenten zu ermöglichen, ist eine elektrische Verbindung von der Gehäuseinnenseite zur Gehäuseaußenseite notwendig.

Die Schaltungsträger für derartige Steuerungen werden in der Regel aufgebaut, in ein Gehäuse eingebracht und anschließend wird dieses Gehäuse verschlossen. Ein Beispiel hierfür wird in der DE 10 2007 038 331 A1 beschrieben. Dieser Gehäuseaufbau garantiert jedoch keine absolute Dichtheit gegen Diffusion bzw. Permeation. Schadgase können im Laufe der Zeit zu dem Schaltungsträger gelangen und zu Metallkorrosion führen.

Bei einem alternativen Konzept wird der komplette Schaltungsaufbau zum Schutz des Schaltungsträgers vollständig mit Moldmasse umgossen. Ein Beispiel hierfür wird in der DE 10 2011 082 537 A1 beschrieben. Die Prozessführung des Moldprozesses muss dabei genau eingehalten werden. Ansonsten kann es bei der Verwendung von ungehäusten elektronischen Bauteilen, sogenannten Bare Dies, die mittels Gold-Draht-Verbindungen mit dem Schaltungsträger elektrisch verbunden sind, zu sogenannten Bonddrahtverwehungen kommen. Ferner muss der thermische Ausdehnungskoeffizient des Moldmaterials genau an den des Gesamtaufbaus, bestehend aus Trägersubstrat, Bauteile usw. angepasst sein. Ansonsten kann es bei Temperaturbelastungen zu Spaltbildung zwischen Moldmasse und Aufbau kommen.

Eine weitere Möglichkeit des Abdichtens des Schaltungsraumes ist das Verschweißen des Gehäuses mit einem Edelstahldeckel. Dieses Verfahren ist vergleichsweise kostenintensiv und die elektrischen Anschlüsse müssen insbesondere über Glasdurchführungen vom Schaltungsträger durch das Edelstahlgehäuse nach außen geführt werden. Hier kann es leicht zu Fehlern im Prozess kommen. Des Weiteren können Gase, die durch den Schweißprozess im Gehäuseinneren entstehen, nur schwer wieder abgeführt werden.

Die DE102012215230A1 beschreibt ein Elektronikmodul mit Deckel und anspritzbarem Kunststoff-Dichtricht, insbesondere für ein Kfz-Steuergerät, wobei über den Kunststoff-Dichtring eine formschlüssige Verbindung zwischen dem Deckel und einem Leiterplattenelement bereitgestellt wird.

Aus der DE102010062653A1 ist Steuermodul und ein Verfahren zu dessen Herstellung bekannt. Die DE102012213917A1 bezieht sich auf eine Bauelementummantelung für ein Elektronikbauteil, wobei ein formschlüssige Verbindung zwischen dem Mantelelement und der Leiterplatte bereitgestellt wird.

Der Erfindung liegt die Aufgabe zu Grunde, ein Steuergerät für ein Kraftfahrzeug zu schaffen, das einen vollständigen Schutz von Schaltung und Schaltungsträger gegen Schadgase und gegen aggressive Medien wie Getriebeöl bietet und gleichzeitig im Vergleich zu bisher bekannten Steuergeräten zu einer Reduzierung der Herstellungskosten führt.

Diese Aufgabe wird erfindungsgemäß gelöst durch ein Steuergerät mit den Merkmalen des Anspruchs 1.

Erfindungsgemäß wird ein Steuergerät beschrieben, das einen Gehäusedeckel mit einem umlaufenden, insbesondere planen, Randbereich und eine flächige, elektrische Verbindungsvorrichtung mit integrierten Leiterbahnen umfasst, wobei der Gehäusedeckel im Randbereich mit der Verbindungsvorrichtung unter Bildung einer Verbindungsnaht zumindest abschnittsweise stoffschlüssig verbunden ist und mit der Verbindungsvorrichtung einen Hohlraum einschließt. Die stoffschlüssige Verbindung zwischen dem Gehäusedeckel und der Verbindungsvorrichtung ist insbesondere mittels Kleben, Laminieren oder Löten hergestellt.

Auf der Verbindungsvorrichtung ist mindestens ein elektronisches Bauteil innerhalb des Hohlraums angeordnet und die Verbindungsvorrichtung verbindet dieses elektronische Bauteil mit elektronischen Bauteilen außerhalb des Hohlraums elektrisch. Der Gehäusedeckel ist dabei auf seiner gesamten Oberfläche und über den umlaufenden Randbereich hinaus mit einem Polymer mediendicht umspritzt, wobei der Gehäusedeckel bevorzugt aus Kunststoff oder aus Metall ist und das Polymer vorwiegend als Moldmaterial, als Kleber oder als Harz ausgeführt ist.

Die elektronischen Bauteile umfassen beispielsweise Kondensatoren, Spulen oder einen Mikroprozessor. In der Regel sind die elektronischen Bauteile über Leiterbahnen der Verbindungsvorrichtung und/oder mittels gebondeter Golddrähte miteinander elektrisch verbunden.

Der Gehäusedeckel schützt die elektronischen Bauteile im Inneren des Steuergerätgehäuses vor Ölen, insbesondere aggressiven Ölen, sowie schädlichen Gasen und Chemikalien. Weiterhin sind die elektronischen Bauteile vor Salzen oder Verarbeitungsrückständen geschützt. Die Öle, Gase, Salze und/oder Rückstände liegen beispielsweise in einem Getriebe vor, an welchem oder innerhalb welchem das Steuergerät angeordnet ist. Auch die entsprechenden Leiterbahnen werden von dem Gehäusedeckel geschützt. Hierzu ist der Deckel, wie bereits erwähnt, im Randbereich stoffschlüssig mit der Verbindungsvorrichtung so verbunden, dass mit der Verbindungsvorrichtung ein abgeschlossener Hohlraum um die elektronischen Bauteile gebildet wird. Zusätzlich ist der Gehäusedeckel dabei über den umlaufenden Randbereich hinaus insbesondere komplett mit einem Polymer mediendicht umspritzt. Vorteilhafterweise kann dadurch auch ein Gehäusedeckel aus nicht mediendichtem Material, der damit in der Regel auch kostengünstiger ist, verwendet werden. Somit ist der Steuergerätaufbau gegen die Umgebung hermetisch abgedichtet.

Im Gegensatz zu formschlüssig verbundenen Deckeln können insbesondere im Bereich der Verbindungsnaht keine Fluide und/oder Gase in den Hohlraum eintreten. Somit sind die elektronischen Komponenten versiegelt und gegen die Umwelt abgedichtet. Zusätzlich kann auf gummiartige Dichtungen verzichtet werden, welche insbesondere bei formschlüssig angebundenen Deckeln verwendet werden. Diese Dichtungen würden keine vollständige Gasdichtigkeit garantieren, da die Gase im Laufe der Zeit durch derartige Dichtungen in erheblichem Maße diffundieren können.

Insbesondere umfassen die Chemikalien beziehungsweise Gase Schwefelverbindungen, wodurch Sulfide entstehen können. Sulfide sind zumindest teilweise stromleitend und würden sich an ungeschützten elektronischen Komponenten, den Leiterbahnen der Verbindungsvorrichtung und/oder den Golddrähten ablagern. Dabei kann es zu chemischen Reaktionen mit den Sulfiden kommen. Beispielsweise oxidieren die Leiterbahnen der Verbindungsvorrichtung, insbesondere Silberleiterbahnen, mit den Schwefelverbindungen. Dabei können sich Leitungswider-stände und/oder Funktionen der elektronischen Komponenten verändern und beispielsweise das Schaltverhalten eines Getriebes negativ beeinflussen. Weiterhin können derartige Gase Signalveränderungen bewirken, sodass es beispielsweise zu fehlerhaften Auswertungen durch die Steuergerätevorrichtung kommt.

Insgesamt werden somit mittels des beschriebenen Aufbaus die Lebensdauer und die Genauigkeit des Steuergeräts verbessert. Weiter ist das beschriebene Steuergerät als vorgefertigtes Modul für eine Anwendung vorort wie beispielsweise im Getriebe oder als Anbausteuergerät realisierbar.

Gemäß einer weiteren Ausgestaltung ist die Verbindungsvorrichtung als Leiterplatte mit mindestens einer Lage ausgeführt. Die Leiterplatte ist beispielsweise eine faserverstärkte Kunststoff- oder eine Keramikleiterplatte. Es könnte aber auch eine sogenannte HDI-Leiterplatte (High-Density-Interconnect) verwendet werden, welche sehr kompakt ausgestaltet ist. Die durchgehende Leiterplatte ragt hier über den gesamten umlaufenden Randbereich des Gehäusedeckels hinaus und bildet gleichzeitig den Boden des Gehäuses. Dadurch wird insbesondere ein flacher Aufbau des Steuergerätes erreicht.

Um eine zusätzliche Versteifung dieses Aufbaus zu erreichen bzw. eine unter Umständen auftretende Verwölbung des Aufbaus im Bereich der Leiterplatte auszugleichen, kann der auf der dem Gehäusedeckel abgewandten Seite der Leiterplatte in dem der Verbindungsnaht entsprechenden Bereich zusätzlich Polymer aufgespritzt sein.

Um den Niveauunterschied zwischen dem Randbereich des Deckels und der Leiterplatte im Bereich der Umspritzung zu vermindern bzw. zu egalisieren, verläuft der umlaufende Randbereich des Gehäusedeckels vorteilhafter Weise in einer entsprechenden umlaufenden Nut in der Leiterplatte. Dadurch wird das Risiko einer Spaltbildung in der Umspritzung im Bereich der Verbindungsstelle reduziert.

Gemäß einer weiteren Ausgestaltung ist die Verbindungsvorrichtung zum Teil als separater Schaltungsträger im Inneren des Hohlraums angeordnet, wobei auf dem separaten Schaltungsträger das mindestens eine elektronische Bauteil wie Kondensator, Spule oder Mikroprozessor angeordnet ist. Die elektronischen Bauteile sind insbesondere über Leiterbahnen des Schaltungsträgers und/oder mittels gebondeter Golddrähte miteinander elektrisch verbunden. Der separate Schaltungsträger ist beispielsweise eine faserverstärkte Kunststoff- oder eine Keramikleiterplatte mit je einer oder mehreren Lagen. Alternativ könnte aber auch eine sogenannte HDI-Leiterplatte (High-Density-Interconnect) verwendet werden, welche konstruktionsbedingt sehr kompakt ausgestaltet ist.

Das mindestens eine elektronische Bauteil auf dem separaten Schaltungsträger ist bevorzugt mittels einer separaten Leiterplatte mit elektronischen Bauteilen außerhalb des Hohlraums elektrisch verbunden. Als separate Leiterplatte wird insbesondere eine flexible Leiterplatte, die ganzflächig, mit einer Aussparung zur Aufnahme des separaten Schaltungsträgers, oder streifenförmig ausgeführt ist, verwendet. Bei diesem Ausführungsbeispiel sind der separate Schaltungsträger und die separate Leiterplatte auf einer gemeinsamen, über den gesamten umlaufenden Randbereich des Gehäusedeckels hinaus ragenden Trägerplatte angeordnet. Hier wird der Hohlraum im Steuergerät im Wesentlichen durch den Gehäusedeckel und die Trägerplatte umschlossen. In der Regel ist die Trägerplatte wegen ihrer Anforderungen in Bezug auf Steifigkeit und Wärmeableitvermögen aus Metall, insbesondere aus Aluminium gefertigt. Wird als separate Leiterplatte eine Flexfolie verwendet, so ist diese bevorzugt auf die Trägerplatte auflaminiert. Wenn die flexible Leiterplatte vollflächig mit einer Aussparung zur Aufnahme des Schaltungsträgers ausgeführt ist, wird diese im Wesentlichen vom Randbereich des Gehäusedeckels vollständig umlaufend überdeckt. Wenn die flexible Leiterplatte streifenförmig ausgeführt ist, wird diese vom umlaufenden Randbereich des Gehäusedeckels naturgemäß nur abschnittsweise, in der Regel quer zu den Leiterbahnen überdeckt.

In einer weiteren Ausgestaltung verläuft der umlaufende Randbereich des Gehäusedeckels vorteilhafter Weise in einer entsprechenden umlaufenden Nut in der Trägerplatte. Dadurch wird der Niveauunterschied zwischen dem Randbereich des Deckels und Trägerplatte im Bereich der Umspritzung verkleinert oder gar egalisiert und somit das Risiko einer Spaltbildung im Polymer im Bereich der Verbindungsnaht reduziert.

Gemäß einer weiteren Ausgestaltung ist im Gehäusedeckel eine Öffnung angeordnet, durch die vor der Umspritzung ein Schutzgel in den Hohlraum eingebracht werden kann, das zumindest die elektronischen Bauelemente auf der Verbindungsvorrichtung bedeckt. Es wäre auch denkbar, den gesamten Hohlraum mit dem Schutzgel zu vergießen. Nach dem Einbringen des Schutzgels wird die Öffnung des Gehäusedeckels mittels eines Klebers, einer kugelartigen Verschlussvorrichtung oder eines Polymermaterials dicht verschlossen. Das Schutzgel bedeutet einen zusätzlichen Schutz der Elektronik in dem Steuergerät.

Eine weitere Aufgabe der Erfindung ist es, ein Verfahren zum Herstellen des erfindungsgemäßen Steuergerätes zu schaffen. Diese Aufgabe wird erfindungsgemäß gelöst durch ein Verfahren mit den Merkmalen des Anspruchs 15.

Das Verfahren umfasst die Schritte:
- Bereitstellen der Verbindungsvorrichtung, auf welcher die elektronischen Bauteile angeordnet sind,
- Bereitstellen des Gehäusedeckels,
- stoffschlüssiges Verbinden des Gehäusedeckels mit der Verbindungsvorrichtung derart, dass dieser mit der Verbindungsvorrichtung einen abgeschlossenen Hohlraum bildet, in welchem sich die elektronischen Bauteile befinden,
- Umspritzen des Gehäusedeckels mit einem Polymer derart, dass das umspritzte Polymer über den umlaufenden Randbereich des Gehäusedeckels hinausreicht.

In einer weiteren Ausgestaltung des Verfahrens wird vor dem Umspritzen des Gehäusedeckels mit einem Polymer durch eine Öffnung im Gehäusedeckel insbesondere ein Schutzgel in den Hohlraum eingebracht, das mindestens die elektronischen Bauelemente auf der Verbindungsvorrichtung bedeckt. Es wäre auch möglich, den gesamten Hohlraum mit dem Schutzgel zu vergießen. Nach dem Einbringen des Schutzgels wird die Öffnung des Gehäusedeckels mittels eines Klebers, einer kugelartigen Verschlussvorrichtung oder eines Polymermaterials dicht verschlossen.

Weitere Merkmale, Vorteile und Einzelheiten sind der nachfolgenden Beschreibung entnehmbar, in der bevorzugte Ausführungsbeispiele näher erläutert werden. Es zeigen:
- Fig. 1: einen Schnitt durch ein Steuergerät mit einer durchgehenden Leiterplatte als Verbindungsvorrichtung,
- Fig. 2: ein Steuergerät wie in der Figur 1, mit beidseitig aufgebrachtem Polymer,
- Fig. 3: einen Schnitt durch ein Steuergerät mit einem separaten Schaltungsträger und einer separaten Leiterplatte,
- Fig. 4: ein Steuergerät wie in der Figur 3, jedoch mit einer Nut in der Trägerplatte, und
- Fig. 5: ein Steuergerät wie in der Figur 3, jedoch mit Schutzgel im Hohlraum.

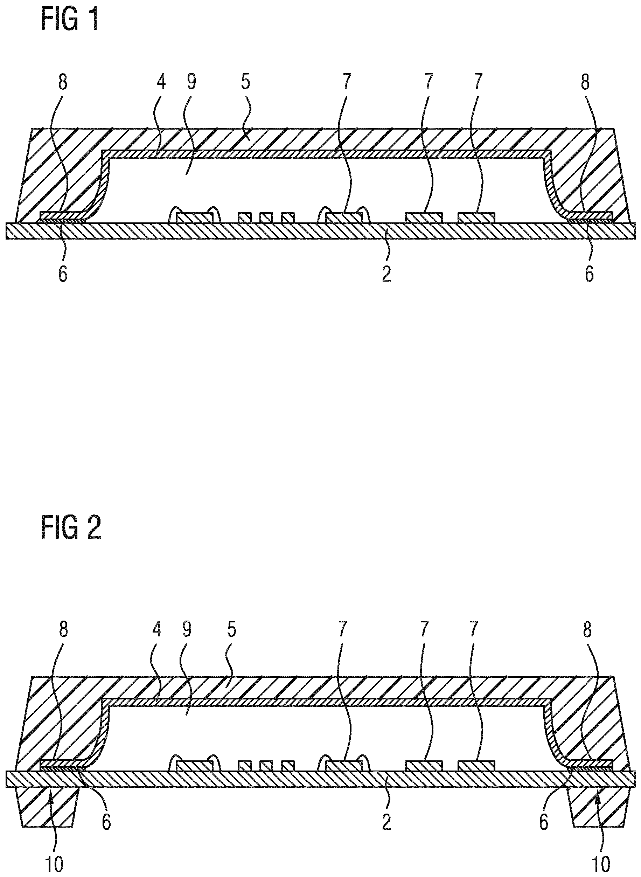

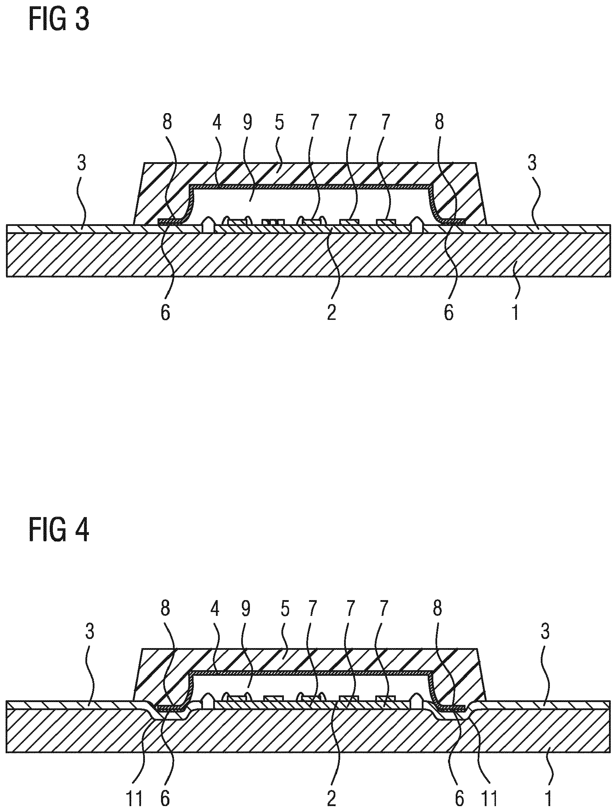

Figuren 1 und 2, bzw. 3 bis 5 zeigen schematische Schnittansichten eines Steuergerätes gemäß zweier unterschiedlicher Ausführungsprinzipien, wobei Fig. 1 und Fig. 2 das erste und Fig. 3 bis 5 das zweite Ausführungsprinzip wiedergeben. Zunächst werden Gemeinsamkeiten der zwei Ausführungsprinzipien beschrieben, ehe auf die Unterschiede eingegangen wird.

Bei den Ausführungsbeispielen handelt es sich um ein Steuergerät eines Automatikgetriebes eines Kraftfahrzeuges. Das Steuergerät vermag beispielsweise Messwerte von Sensoren wie Hall-Sensoren auszuwerten und eine Schaltung des Automatikgetriebes in Abhängigkeit der Messwerte zu steuern. Alternativ kann das Steuergerät auch für andere Einsatzzwecke wie zum Beispiel in einem Motor eines Kraftfahrzeuges vorgesehen sein.

Jedes Steuergerät weist eine Verbindungsvorrichtung 2, 3 auf. Auf der Verbindungsvorrichtung 2, 3 ist eine Mehrzahl von elektronischen Bauteilen 7 angeordnet. Diese umfassen beispielsweise Kondensatoren, Spulen, wenigstens einen Mikroprozessor und/oder andere Komponenten. Die elektronischen Bauteile 7 sind miteinander elektrisch verbunden, insbesondere über gebondete Golddrähte und/oder Leiterbahnen der Verbindungsvorrichtung 2, 3.

Zum Schutz der elektronischen Bauteile 7 und der entsprechenden Leiterbahnen ist ein Gehäusedeckel 4 in seinem umlaufenden Randbereich 8 mit der Verbindungsvorrichtung 2, 3 unter Ausbildung einer umlaufenden Verbindungsnaht 6 stoffschlüssig verbunden. Die stoffschlüssige Verbindung zwischen dem Gehäusedeckel 4 und der Verbindungsvorrichtung 2, 3 ist mittels Kleben hergestellt. Diese Verbindung kann aber auch zum Beispiel durch Laminieren oder Löten realisiert sein. Der Gehäusedeckel 4 ist wahlweise aus Metall oder Kunststoff gefertigt.

Der Gehäusedeckel 4 umschließt mit der Verbindungsvorrichtung 2, 3 einen abgeschlossenen Hohlraum 9. Somit ist die stoffschlüssige Verbindungsnaht 6 zusammenhängend zwischen dem Gehäusedeckel 4 und der Verbindungsvorrichtung 2, 3 um die elektronischen Bauteile 7 ausgebildet.

Die Verbindungsvorrichtung 2, 3 verbindet die elektronischen Bauteile 7 im Inneren des Steuergeräts mit hier nicht gezeigten elektronischen Bauteilen außerhalb des Hohlraums 9 bzw. Steuergeräts elektrisch.

Der Gehäusedeckel 4 ist komplett und über seinen umlaufenden Randbereich 8 hinaus mit einem Polymer 5 mediendicht umspritzt. Dadurch kann auch ein Gehäusedeckel 4 aus nicht mediendichtem Material, der damit in der Regel auch kostengünstiger ist, verwendet werden.

Der umlaufende Randbereich 8 des Gehäusedeckels 4 ist dabei mindestens im Bereich der Verbindungsnaht 6 zwischen dem Gehäusedeckel 4 und der Verbindungsvorrichtung 2, 3 mit einem Polymer 5 insbesondere derart umspritzt, dass sich das Polymer 5 in der vom Gehäusedeckel 4 abgewandten Richtung über den Randbereich 8 hinaus über die Verbindungsvorrichtung 2, 3 beispielsweise zumindest der Breite des Randbereichs 8 nach erstreckt. Die Breite der Umspritzung hängt unter anderem von der Art des verwendeten Polymers 5 und von der Oberflächenbeschaffenheit der umspritzten Flächen ab. Zum Beispiel können der Randbereich 8 und die Verbindungsvorrichtung 2,3 jeweils plan ausgeführt sein. Alternativ können der Randbereich 8 und die Verbindungsvorrichtung 2,3 je eine entsprechende Struktur aufweisen, die im zusammengefügten Zustand zu einer verbesserten Festigkeit und Dichtheit der Verbindung, vor allem über die Lebensdauer, erzeugen kann. Dadurch ist sichergestellt, dass der Bereich der Verbindungsnaht 6 zwischen dem Gehäusedeckel 4 und der Verbindungsvorrichtung 2, 3 ausreichend mit Polymermaterial 5 bedeckt ist, und somit der Steuergerätaufbau insbesondere in diesem Bereich gegen die Umgebung, beispielweise Öle, insbesondere aggressive Öle, sowie schädliche Gase und Chemikalien hermetisch abgedichtet ist. Das Polymer 5 ist als Moldmaterial, alternativ dazu als Kleber oder als Harz ausgeführt.

Im Folgenden werden die Unterschiede der zwei Ausführungsprinzipien gemäß den Figuren 1 bis 5 erläutert.

Im Ausführungsbeispiel gemäß Figur 1 ist die Verbindungsvorrichtung als Leiterplatte 2 mit mindestens einer Lage ausgeführt. Die Leiterplatte 2 ist beispielsweise eine faserverstärkte Kunststoff-, eine Keramikleiterplatte oder eine HDI-Leiterplatte. Die durchgehende Leiterplatte 2 ragt hier über den gesamten umlaufenden Randbereich 8 des Gehäusedeckels 4 hinaus und bildet gleichzeitig den Boden des Steuergerätgehäuses. Dadurch wird insbesondere ein flacher Aufbau des Steuergerätes erreicht.

Um eine zusätzliche Versteifung des Steuergeräteaufbaus zu erreichen bzw. um eine unter Umständen auftretende Verwölbung des Aufbaus im Bereich der Leiterplatte 2 auszugleichen, kann, wie in Fig. 2 gezeigt, auf der dem Gehäusedeckel 4 abgewandten Seite der Leiterplatte 2 in dem der Verbindungsnaht 6 entsprechenden Bereich 10 zusätzlich Polymer 5 aufgespritzt sein.

Im Ausführungsbeispiel gemäß Figur 3 umfasst die Verbindungsvorrichtung 2, 3 einen separaten Schaltungsträger 2, auf dem alle elektronischen Bauteile 7 angeordnet sind, und eine separate Leiterplatte 3 mittels der die elektronischen Bauteile 7 im Inneren des Steuergerätes mit nicht gezeigten elektronischen Bauteilen außerhalb des Steuergerätes elektrisch verbunden sind. Der separate Schaltungsträger 2 und die separate Leiterplatte 3 sind hier mittels Bonddrähten verbunden. Der separate Schaltungsträger 2 und die separate Leiterplatte 3 sind auf einer gemeinsamen, über den gesamten umlaufenden Randbereich 8 des Gehäusedeckels 4 hinaus ragenden Trägerplatte 1 angeordnet. Hier wird der Hohlraum 9 im Wesentlichen durch den Gehäusedeckel 4 und die Trägerplatte 1 umschlossen.

Der separate Schaltungsträger 2 ist als eine faserverstärkte Kunststoffleiterplatte oder alternativ als eine Keramikleiterplatte oder HDI-Leiterplatte mit jeweils einer oder mehreren Lagen ausgeführt. Es können jedoch auch andere Ausgestaltungsformen eines Schaltungsträgers Verwendung finden. Die elektronischen Bauteile 7 sind miteinander elektrisch verbunden, insbesondere über gebondete Golddrähte und/oder Leiterbahnen des separaten Schaltungsträgers 2.

Als separate Leiterplatte 3 wird bevorzugt eine flexible Leiterplatte aus Polyimid verwendet. Diese flexible Leiterplatte 3 ist entweder als geschlossenen Fläche, mit einer Aussparung zur Aufnahme des Schaltungsträgers 2, oder streifenförmig ausgeführt.

Üblicherweise ist die Trägerplatte wegen ihrer Anforderungen in Bezug auf Steifigkeit und Wärmeableitvermögen aus Metall, insbesondere aus Aluminium gefertigt. Der separate Schaltungsträger 2 und die separate Leiterplatte 3 sind auf die Trägerplatte 1 üblicherweise geklebt oder laminiert. Wenn die flexible Leiterplatte 3 ganzflächig ausgeführt ist, wird diese im Wesentlichen vom Randbereich 8 des Gehäusedeckels 4 vollständig umlaufend überdeckt.

Falls die flexible Leiterplatte 3 streifenförmig ausgeführt ist, wird diese vom umlaufenden Randbereich 8 des Gehäusedeckels 4 konstruktionsbedingt nur abschnittsweise, in der Regel quer zu den Leiterbahnen der Leiterplatte 3 überdeckt. Die Verbindungsnaht 6 erstreckt sich somit auf der einen Seite über den umlaufenden Randbereich 8 und auf der anderen Seite über die Streifen der Leiterplatte 3 bzw. die Trägerplatte 1.

Fig. 4 zeigt ein Steuergerät wie in Fig. 3, jedoch verläuft der umlaufende Randbereich 8 des Gehäusedeckels 4 in einer entsprechenden umlaufenden Nut 11 in der Trägerplatte 1. Dadurch wird der Niveauunterschied zwischen dem Randbereich 8 und der Trägerplatte 1 im Bereich der Umspritzung 5 verkleinert bzw. egalisiert und somit das Risiko einer Spaltbildung im Polymer 5 im Bereich der Verbindungsnaht 6 reduziert.

Eine derartige Nut wäre auch im ersten Ausführungsprinzip gemäß den Figuren 1 und 2 entsprechend in der Leiterplatte 2 denkbar.

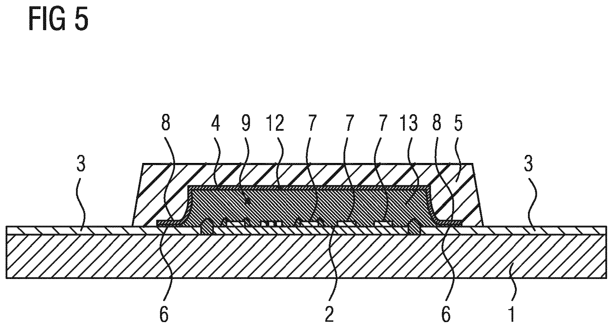

Fig. 5 zeigt ein Steuergerät wie in Fig. 3, jedoch ist im Gehäusedeckel 4 eine Öffnung 12 angeordnet, durch die vor der Umspritzung mit Polymer 5 ein Schutzgel 13 in den Hohlraum 9 eingebracht worden ist, das in der Regel zumindest die elektronischen Bauelemente 7 auf der Verbindungsvorrichtung 2 bedeckt. Hier ist der gesamte Hohlraum 9 mit dem Schutzgel 13 vergossen. Nach dem Einbringen des Schutzgels 13 ist die Öffnung 12 des Gehäusedeckels 4 mittels eines Klebers, einer kugelartigen Verschlussvorrichtung oder eines Polymermaterials dicht verschlossen worden. Das Schutzgel 13 bedeutet einen zusätzlichen Schutz der Elektronik in dem Steuergerät.

Ein derartiges Einbringen eines Schutzgels 13 wäre auch im ersten Ausführungsprinzip gemäß den Figuren 1 und 2 denkbar.

### Bezugszeichenliste

- 1: Trägerplatte
- 2: Verbindungsvorrichtung, separater Schaltungsträger
- 3: Verbindungsvorrichtung, separate Leiterplatte
- 4: Gehäusedeckel
- 5: Polymer
- 6: Verbindungsnaht
- 7: Bauteil
- 8: umlaufenden Randbereich des Gehäusedeckels 4
- 9: Hohlraum
- 10: Bereich
- 11: Nut
- 12: Öffnung im Gehäusedeckel 4
- 13: Schutzgel

## Patentansprüche

1. Steuergerät in einem Kraftfahrzeug, umfassend
a) einen Gehäusedeckel (4) mit einem umlaufenden Randbereich (8) ,
b) eine flächige, elektrische Verbindungsvorrichtung (2, 3) mit integrierten Leiterbahnen, wobei der Gehäusedeckel (4) im Randbereich (8) zumindest mit der Verbindungsvorrichtung (2, 3) unter Ausbildung einer Verbindungsnaht (6) stoffschlüssig verbunden ist und mit der Verbindungsvorrichtung (2, 3) einen Hohlraum (9) bildet,
c) mindestens ein elektronisches Bauteil (7) innerhalb des Hohlraums (9), wobei die Verbindungsvorrichtung (2, 3) das mindestens eine elektronische Bauteil (7) mit elektronischen Bauteilen außerhalb des Hohlraums (9) elektrisch verbindet,
**wobei**
der Gehäusedeckel (4) über den umlaufenden Randbereich (8) hinaus mit einem Polymer (5) mediendicht umspritzt ist.

2. Steuergerät nach Anspruch 1, **dadurch gekennzeichnet, dass** die Verbindungsvorrichtung (2) als Leiterplatte mit mindestens einer Lage ausgeführt ist, wobei die Leiterplatte (2) über den gesamten umlaufenden Randbereich (8) des Gehäusedeckels (4) hinausragt.

3. Steuergerät nach Anspruch 2, **dadurch gekennzeichnet, dass** auf der dem Gehäusedeckel (4) abgewandten Seite der Leiterplatte (2) in dem der Verbindungsnaht (6) entsprechenden Bereich (10) zusätzlich Polymer (5) aufgespritzt ist.

4. Steuergerät nach Anspruch 2 oder 3, **dadurch gekennzeichnet, dass** der umlaufende Randbereich (8) des Gehäusedeckels (4) in einer umlaufenden Nut (11) in der Leiterplatte (2) verläuft.

5. Steuergerät nach Anspruch 1, **dadurch gekennzeichnet, dass** die Verbindungsvorrichtung (2, 3) als separater Schaltungsträger (2) im Inneren des Hohlraums (9) ausgeführt ist, wobei auf dem separaten Schaltungsträger (2) das mindestens eine elektronische Bauteil (7) angeordnet ist, welches mittels einer separaten Leiterplatte (3) mit elektronischen Bauteilen außerhalb des Hohlraums (9) elektrisch verbunden ist, und wobei der separate Schaltungsträger (2) und die separate Leiterplatte (3) auf einer gemeinsamen, über den gesamten umlaufenden Randbereich (8) des Gehäusedeckels (4) hinausragenden Trägerplatte (1) angeordnet sind.

6. Steuergerät nach Anspruch 5, **dadurch gekennzeichnet, dass** die separate Leiterplatte (3) als flexible Leiterplatte ausgeführt ist

7. Steuergerät nach Anspruch 5 oder 6, **dadurch gekennzeichnet, dass** die separate Leiterplatte (3) zumindest abschnittsweise von dem umlaufenden Randbereich (8) überdeckt ist.

8. Steuergerät nach einem der Ansprüche 5 bis 7, **dadurch gekennzeichnet, dass die** Trägerplatte (1) aus Metall, zum Beispiel Aluminium ist.

9. Steuergerät nach einem der Ansprüche 5 bis 8, **dadurch gekennzeichnet, dass** der umlaufende Randbereich (8) des Gehäusedeckels (4) in einer umlaufenden Nut (11) in der Trägerplatte (1) verläuft.

10. Steuergerät nach einem der vorhergehenden Ansprüche, **dadurch gekennzeichnet, dass** das Polymer als Moldmaterial, als Kleber oder als Harz ausgeführt ist.

11. Steuergerät nach einem der vorhergehenden Ansprüche, **dadurch gekennzeichnet, dass** der Gehäusedeckel (4) aus Kunststoff oder aus Metall ist.

12. Steuergerät nach einem der vorhergehenden Ansprüche, **dadurch gekennzeichnet, dass** die stoffschlüssige Verbindung zwischen Gehäusedeckel (4) und der Verbindungsvorrichtung (2, 3) mittels Kleben, Laminieren oder Löten hergestellt ist.

13. Steuergerät nach einem der vorhergehenden Ansprüche, **dadurch gekennzeichnet, dass** im Gehäusedeckel (4) eine Öffnung (12) angeordnet ist, durch die ein Schutzgel (13) in den Hohlraum (9) eingebracht ist, das zumindest die elektronischen Bauelemente (7) auf der Verbindungsvorrichtung (2, 3) bedeckt.

14. Steuergerät nach Anspruch 13, **dadurch gekennzeichnet, dass** die Öffnung (12) mittels eines Klebers, einer kugelartigen Verschlussvorrichtung oder Polymermaterial (5) verschlossen ist.

15. Verfahren zum Herstellen einer Steuergerätevorrichtung nach einem der Ansprüche 1 bis 14, umfassend die Schritte
- Bereitstellen der Verbindungsvorrichtung (2, 3), auf welcher die elektronischen Bauteile (7) angeordnet sind,
- Bereitstellen des Gehäusedeckels (4);
- stoffschlüssiges Verbinden des Gehäusedeckels (4) mit der Verbindungsvorrichtung (2, 3) derart, dass dieser mit der Verbindungsvorrichtung (2, 3) einen abgeschlossenen Hohlraum (5) bildet, in welchem sich die elektronischen Bauteile (7) befinden,
- Umspritzen des Gehäusedeckels (4) mit einem Polymer derart, dass das umspritzte Polymer über den umlaufenden Randbereich (8) des Gehäusedeckels (4) hinaus reicht.

16. Verfahren nach Anspruch 15, wobei vor dem Umspritzen des Gehäusedeckels (4) durch eine Öffnung (12) im Gehäusedeckel (4) ein Schutzgel (13) in den Hohlraum (9) eingebracht wird, das mindestens die elektronischen Bauelemente (7) auf der Verbindungsvorrichtung (2, 3) bedeckt, und wobei anschließend die Öffnung (12) dicht verschlossen wird.

## Claims

1. Control device in a motor vehicle, comprising
a) a housing cover (4) with a peripheral edge region (8),
b) a flat, electrical connecting apparatus (2, 3) with integrated conductor tracks, wherein the housing cover (4), in the edge region (8), is cohesively connected at least to the connecting apparatus (2, 3) so as to form a connecting seam (6) and forms a cavity (9) with the connecting apparatus (2, 3),
c) at least one electronic component (7) within the cavity (9), wherein the connecting apparatus (2, 3) electrically connects the at least one electronic component (7) to electronic components outside the cavity (9) ,
wherein
the housing cover (4) is encapsulated by injection molding in a media-tight manner by a polymer (5) beyond the peripheral edge region (8).

2. Control device according to Claim 1, **characterized in that** the connecting apparatus (2) is designed as a printed circuit board with at least one layer, wherein the printed circuit board (2) projects beyond the entire peripheral edge region (8) of the housing cover (4).

3. Control device according to Claim 2, **characterized in that** polymer (5) is additionally sprayed onto that side of the printed circuit board (2) which is averted from the housing cover (4) in the region (10) which corresponds to the connecting seam (6).

4. Control device according to Claim 2 or 3, **characterized in that** the peripheral edge region (8) of the housing cover (4) runs in a peripheral groove (11) in the printed circuit board (2).

5. Control device according to Claim 1, **characterized in that** the connecting apparatus (2, 3) is designed as a separate circuit carrier (2) in the interior of the cavity (9), wherein the at least one electronic component (7) which is electrically connected to electronic components outside the cavity (9) by means of a separate printed circuit board (3) is arranged on the separate circuit carrier (2), and
wherein the separate circuit carrier (2) and the separate printed circuit board (3) are arranged on a common carrier plate (1) which projects beyond the entire peripheral edge region (8) of the housing cover (4).

6. Control device according to Claim 5, **characterized in that** the separate printed circuit board (3) is designed as a flexible printed circuit board.

7. Control device according to Claim 5 or 6, **characterized in that** the separate printed circuit board (3) is overlapped at least in sections by the peripheral edge region (8).

8. Control device according to one of Claims 5 to 7, **characterized in that** the carrier plate (1) is composed of metal, for example aluminum.

9. Control device according to one of Claims 5 to 8, **characterized in that** the peripheral edge region (8) of the housing cover (4) runs in a peripheral groove (11) in the carrier plate (1).

10. Control device according to one of the preceding claims, **characterized in that** the polymer is designed as molding material, as adhesive or as resin.

11. Control device according to one of the preceding claims, **characterized in that** the housing cover (4) is composed of plastic or of metal.

12. Control device according to one of the preceding claims, **characterized in that** the cohesive connection between the housing cover (4) and the connecting apparatus (2, 3) is established by means of adhesive bonding, lamination or soldering.

13. Control device according to one of the preceding claims, **characterized in that** an opening (12) is arranged in the housing cover (4), a protective gel (13) being introduced into the cavity (9) through said opening, said protective gel at least covering the electronic components (7) on the connecting apparatus (2, 3).

14. Control device according to Claim 13, **characterized in that** the opening (12) is closed by means of an adhesive, a spherical closure apparatus or polymer material (5).

15. Method for producing a control device apparatus according to one of Claims 1 to 14, comprising the steps of:
- providing the connecting apparatus (2, 3) on which the electronic components (7) are arranged,
- providing the housing cover (4),
- cohesively connecting the housing cover (4) to the connecting apparatus (2, 3) in such a way that said housing cover forms, with the connecting apparatus (2, 3), a closed-off cavity (5) in which the electronic components (7) are located,
- encapsulating the housing cover (4) by injection molding with a polymer in such a way that the polymer which provides encapsulation by injection molding extends beyond the peripheral edge region (8) of the housing cover (4).

16. Method according to Claim 15, wherein a protective gel (13) which covers at least the electronic components (7) on the connecting apparatus (2, 3) is introduced into the cavity (9) through an opening (12) in the housing cover (4) before the housing cover (4) is encapsulated by injection molding, and wherein the opening (12) is then sealed in a leak-tight manner.

## Revendications

1. Unité de commande située dans un véhicule automobile, ladite unité comprenant
a) un couvercle de boîtier (4) pourvu d'une zone de bord périphérique (8),
b) un dispositif de liaison électrique (2, 3), sensiblement bidimensionnelle, pourvu de pistes conductrices intégrées, le couvercle de boîtier (4) étant relié par une liaison de matière dans la zone de bord (8) au moins au dispositif de liaison (2, 3) avec formation d'un joint de liaison (6) et formant avec le dispositif de liaison (2, 3) une cavité (9),
c) au moins un composant électronique (7) situé à l'intérieur de la cavité (9), le dispositif de liaison (2, 3) reliant électriquement l'au moins un composant électronique (7) à des composants électroniques situés à l'extérieur de la cavité (9),
le couvercle de boîtier (4) étant surmoulé avec un polymère (5) de manière étanche aux milieux au-delà de la zone de bord périphérique (8).

2. Unité de commande selon la revendication 1, **caractérisée en ce que** le dispositif de liaison (2) est conçu comme une carte de circuit imprimé pourvue d'au moins une couche, la carte de circuit imprimé (2) faisant saillie de toute la zone de bord périphérique (8) du couvercle de boîtier (4).

3. Unité de commande selon la revendication 2, **caractérisée en ce que** du polymère (5) est en plus pulvérisé sur le côté de la carte de circuit imprimé (2) qui est opposé au couvercle de boîtier (4) dans la zone (10) correspondant au joint de liaison (6).

4. Unité de commande selon la revendication 2 ou 3, **caractérisée en ce que** la zone de bord périphérique (8) du couvercle de boîtier (4) s'étend dans une rainure périphérique (11) ménagée dans la carte de circuit imprimé (2).

5. Unité de commande selon la revendication 1, **caractérisée en ce que** le dispositif de liaison (2, 3) est conçu comme un support de circuit séparé (2) situé à l'intérieur de la cavité (9), l'au moins un composant électronique (7), qui est relié électriquement à des composants électroniques situés à l'extérieur de la cavité (9) au moyen d'une carte de circuit séparée (3), étant disposé sur le support de circuit séparé (2), et le support de circuit séparé (2) et la carte de circuit séparée (3) étant disposés sur une plaque de support commune (1) saillant de toute la zone de bord périphérique (8) du couvercle de boîtier (4).

6. Unité de commande selon la revendication 5, **caractérisée en ce que** la carte de circuit imprimé séparée (3) est conçue comme un circuit imprimé souple.

7. Unité de commande selon la revendication 5 ou 6, **caractérisée en ce que** la carte de circuit imprimé séparée (3) est recouverte au moins par portions par la zone de bord périphérique (8).

8. Unité de commande selon l'une des revendications 5 à 7, **caractérisée en ce que** la plaque de support (1) est en métal, par exemple en aluminium.

9. Unité de commande selon l'une des revendications 5 à 8, **caractérisée en ce que** la zone de bord périphérique (8) du couvercle de boîtier (4) s'étend dans une rainure périphérique (11) de la plaque de support (1).

10. Unité de commande selon l'une des revendications précédentes, **caractérisée en ce que** le polymère est conçu comme une matière à mouler, comme une colle ou comme une résine.

11. Unité de commande selon l'une des revendications précédentes, **caractérisée en ce que** le couvercle de boîtier (4) est en matière synthétique ou en métal.

12. Unité de commande selon l'une des revendications précédentes, **caractérisée en ce que** la liaison de matière entre le couvercle de boîtier (4) et le dispositif de liaison (2, 3) est réalisée par collage, laminage ou brasage.

13. Unité de commande selon l'une des revendications précédentes, **caractérisée en ce qu'**une ouverture (12) est ménagée dans le couvercle de boîtier (4), à travers laquelle un gel protecteur (13) est introduit dans la cavité (9), lequel recouvre au moins les composants électroniques (7) situés sur le dispositif de liaison (2, 3).

14. Unité de commande selon la revendication 13, **caractérisée en ce que** l'ouverture (12) est fermée au moyen d'un adhésif, d'un dispositif de fermeture en forme de bille ou d'un matériau polymère (5).

15. Procédé de réalisation d'un dispositif d'unité de commande selon l'une des revendications 1 à 14, ledit procédé comprenant les étapes suivantes
- fournir le dispositif de liaison (2, 3) sur lequel les composants électroniques (7) sont disposés,
- fournir le couvercle de boîtier (4) ;
- relier par une liaison de matière le couvercle de boîtier (4) au dispositif de liaison (2, 3) de telle sorte que celui-ci forme avec le dispositif de liaison (2, 3) une cavité fermée (5) dans laquelle les composants électroniques (7) sont situés,
- Surmouler le couvercle de boîtier (4) avec un polymère de telle sorte que le polymère surmoulé s'étende au-delà de la zone de bord périphérique (8) du couvercle de boîtier (4).

16. Procédé selon la revendication 15, un gel protecteur (13) est introduit dans la cavité (9) par une ouverture (12) ménagée dans le couvercle de boîtier (4) avant de surmouler le couvercle de boîtier (4), lequel gel recouvre au moins les composants électroniques (7) sur le dispositif de liaison (2, 3) et l'ouverture (12) étant ensuite fermée de manière étanche.
